(19) **Europäisches Patentamt / European Patent Office / Office européen des brevets**

(11) **EP 2 284 581 A1**

(12) # EUROPEAN PATENT APPLICATION

(43) Date of publication:
**16.02.2011 Bulletin 2011/07**

(51) Int Cl.:
**G02B 5/30** *(2006.01)*　　**G02B 27/48** *(2006.01)*
**G03F 7/00** *(2006.01)*　　**G03H 1/32** *(2006.01)*

(21) Application number: **10171889.8**

(22) Date of filing: **04.08.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(30) Priority: **07.08.2009 US 232313 P**

(71) Applicant: **JDS Uniphase Corporation**
**Milpitas, CA 95035 (US)**

(72) Inventors:
 • **SHEMO, David M**
　**Windsor, CA 95492 (US)**
 • **TAN, Kim Leong**
　**680441, Singapore (SG)**

(74) Representative: **Harrison Goddard Foote**
**106 Hope Street**
**Glasgow**
**G2 6PH (GB)**

(54) **LC Layers Having a Spatially-Varying Tilt Angle**

(57)　A method of fabricating an optical element including a liquid crystal layer having a spatially-varying tilt angle includes coating a substrate with a linearly photopolymerizable polymer layer, irradiating the linearly photopolymerizable polymer layer with linearly polarized ultra-violet light at a oblique angle, and coating a layer of liquid crystal material on a surface of the irradiated linearly photopolymerizable polymer layer. The liquid crystal material has a predetermined relationship between its tilt angle and a total dose of the linearly polarized ultra-violet light. The linearly photopolymerizable polymer layer is irradiated with at least one dose of linearly polarized ultra-violet light that is sufficient to induce formation of a plurality of discrete regions within the liquid crystal layer having a larger in-plane birefringence than an adjacent or surrounding region.

Fig. 2

**Description**

**CROSS-REFERENCE TO RELATED APPLICATIONS**

This application claims priority from US Provisional Application No. 61/232,313 filed Aug 7,2009.

**MICROFICHE APPENDIX**

Not Applicable.

**TECHNICAL FIELD**

The present application relates generally to liquid crystal (LC) layers having a spatially-varying tilt angle, and in particular, to a method for creating liquid crystal polymer (LCP) having a spatially-varying LCP tilt angle, to optical elements created with the same, and to applications of the LCP.

**BACKGROUND OF THE INVENTION**

Liquid crystals (LC) having spatially varying tilt angles have been used for various applications. For example, diffraction gratings and more complex thin holograms, encoded onto programmable liquid crystal (LC)-based spatial light modulators (SLMs), have been actively researched as a way to alter the wavefront of an optical beam. Although programmable thin holograms encoded onto LC/SLMs are very versatile, these active components are not cost effective for many applications. In addition, these programmable thin holograms are known to provide relatively small steering angles. For example, a state-of-the art LC on Silicon (LCoS) panel may have less than $10\mu m$ pixel pitch, which at a wavelength of $0.5\mu m$ and utilizing a minimum of two pixels per grating period, provides a maximum beam deflection angle of about 1.4 degrees. All other programmable hologram output (e.g., termed the replay) will have even smaller deflection angles.

More recently, there has been increased interest in forming optical components, such as the above-mentioned diffraction gratings and/or more complex thing holograms, using liquid crystal polymer (LCP) having a spatially varying tilt angle. For example, in US Appl. No. 20090009668, Tan et al. propose a polarization-selective diffractive optical element based on an LCP film. The LCP film includes an array of pixels, each of which is encoded with a fixed liquid crystal director such that each liquid crystal director is aligned in a common plane perpendicular to the LCP film and provides a predetermined pattern of out-of-plane tilts.

**SUMMARY OF THE INVENTION**

The instant invention provides a method of forming optical components having LCP layers with a spatially varying tilt angle, such as diffraction gratings and/or more complex holograms. The instant invention also provides optical components including LCPs with a spatially varying tilt angle, and systems including said optical components.

In accordance with one aspect of the instant invention there is provided a method of fabricating an optical element including a liquid crystal layer having a spatially-varying tilt angle, the method comprising the steps of: a) coating a substrate with a linearly photopolymerizable polymer layer; b) irradiating the linearly photopolymerizable polymer layer with linearly polarized ultra-violet light at a oblique angle; and, c) coating a layer of liquid crystal material on a surface of the irradiated linearly photopolymerizable polymer layer, wherein the liquid crystal material has a predetermined relationship between its tilt angle and a total dose of the linearly polarized ultra-violet light, and wherein the linearly photopolymerizable polymer layer is irradiated with at least one dose of linearly polarized ultra-violet light that is sufficient to induce formation of a plurality of discrete regions within the liquid crystal layer having a larger in-plane birefringence than an adjacent region.

**BRIEF DESCRIPTION OF THE DRAWINGS**

Further features and advantages of the present invention will become apparent from the following detailed description, taken in combination with the appended drawings, in which:

Fig. 1a is schematic illustration of a coordinate system relative to an LC layer;

Fig. 1b is a schematic illustration of the coordinate system for the optic axis of the LC layer;

Fig. 1c is a schematic illustration showing a side view of an LC layer on a substrate having a discretely varied tilt axis;

Fig. 1d is a schematic illustration showing a side view of an LC layer on a substrate having a continuously varied tilt axis;

Fig. 2 is a schematic diagram showing a LPUV exposure system setup for LPP for imposing a variable-tilt oblique alignment in an LCP layer;

Fig. 3 is a plot illustrating the in-plane birefringence behaviour versus LPUV dose for the ROP119/ROF5106 system;

Fig. 4 shows an example of LCP tilt-angle grating structure in accordance with one embodiment of the instant invention;

Fig. 5 shows an example of LCP tilt-angle grating structure, in combination with an azimuthal orientation grating, in accordance with another embodiment of the instant invention;

Fig. 6 shows an example of a continuous tilt angle gradient in an LCP layer in accordance with another embodiment of the instant invention;

Fig. 7 shows an example an LCP layer having low-tilt domains (LTD) within a region of an LCP layer having a higher tilt, in accordance with another embodiment of the instant invention;

Fig. 8 shows an example of an LCP layer having LTD nucleated on lower tilt grating lines in accordance with another embodiment of the instant invention;

Fig. 9 is a schematic diagram showing a LD device having a random tilt angle and a uniform azimuthal orientation;

Fig. 10 shows the projection of a uniaxial O-plate director in (a) into in-plane and out-of-plane birefringence components in (b);

Fig. 11 is a plot illustrating the phase difference of a given LC director tilt as compared to an A-plate configured pixel using of an LCP uniaxial material at $\lambda$=400nm; and

Fig. 12 is a schematic diagram illustrating a sub-system of a laser based illumination system including a phase cell with XY random LC director polar tilt, for reducing speckle by temporally vary the phase modulation at each XY site.

It will be noted that throughout the appended drawings, like features are identified by like reference numerals.

## DETAILED DESCRIPTION

The instant invention relates to methods for creating a liquid crystal (LC) material layer having the tilt angle of its director, or optic axis, spatially varied over an area of the substrate on which the LC layer is deposited. The LC material may be a conventional liquid crystal (non-polymer), or a liquid crystal polymer (LCP). The term tilt angle refers to the angle between the optic axis of the LC and the plane of the substrate. For a positive uniaxial LC material, the optic axis is also called the slow axis (SA).

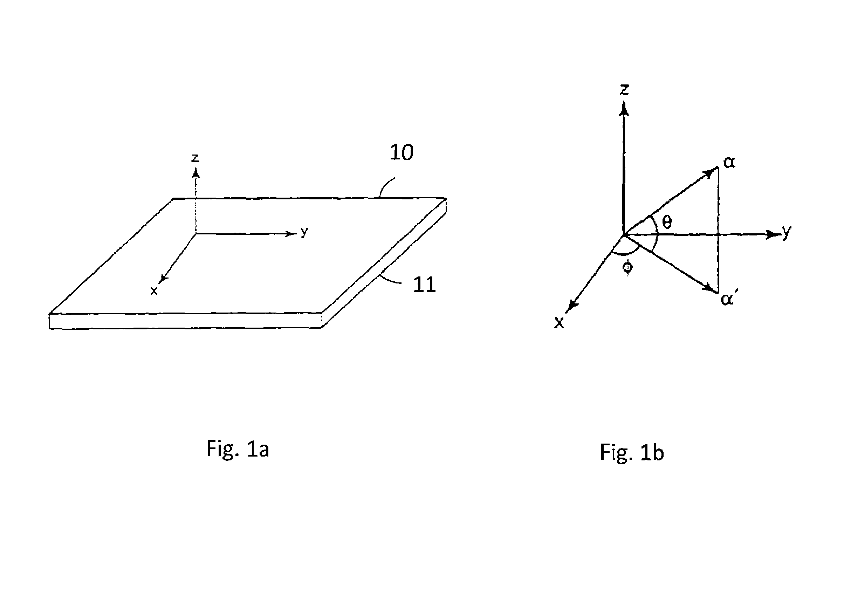

Referring to Fig. 1a, an LC layer 10 is shown disposed on a substrate 11. The plane of the substrate 11 is shown to be parallel to the x-y plane, whereas the z axis is perpendicular to the major surface. In accordance with one embodiment of the instant invention, the tilt axis of the LC layer is spatially varied over an area of the substrate (i.e., varies across the x-y plane). Referring to Fig. 1b, the optical axis, which is depicted as vector $\alpha$, can be defined by a polar angle $\theta$ and an azimuthal angle $\phi$. The azimuthal angle $\phi$ refers to the azimuthal orientation of the optical axis projected in the plane of the substrate, measured relative to some arbitrary reference direction associated with the plane of the substrate (e.g., shown to be the x-axis). The polar angle $\theta$ is the tilt angle of the director and corresponds to the angle at which the vector deviates from the x-y plane.

An LC material having a spatially constant tilt angle equal to 0° is typically referred to as an A-plate, and is said to possess homogenous alignment. An LC material having a spatially constant tilt angle equal to 90° is typically referred to as a C-plate, and is said to possess homeotropic alignment. An LC material having a uniform tilt angle between 0° is 90° is typically referred to as an O-plate, and is understood to have both A-plate and C-plate retardation components.

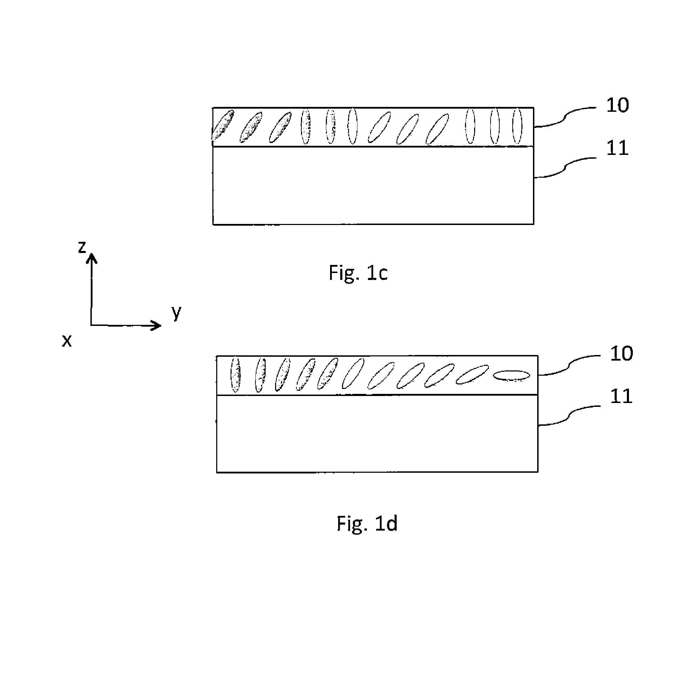

In general, a spatially varying tilt angle means that the tilt angle varies across the surface of the LC layer in a predetermined or random order. For example, with regard to the former, Fig. 1c shows a spatially varied tilt axis having a discrete pattern, whereas Fig. 1d shows a spatially varied tilt axis following a continuous pattern (e.g., a gradient). As the tilt angle of the LC material is varied, also varied is the effective in-plane (or A-plate component) birefringence $\Delta n_A$. For example, as the tilt of a positive uniaxial LC material increases from 0° to 90°, its $\Delta n_A$ value decreases from the LC material's intrinsic $\Delta n$ value to zero. Directly dependent on $\Delta n_A$ is in-plane (A-plate) retardance $\Gamma_A$, which is the product of $\Delta n_A$ *d, where d is the physical thickness of the LC material layer. Therefore, as the tilt angle of the LC material varies, $\Gamma_A$ also varies. Similarly, as the tilt of the LC varies, the out-of-plane (C-plate) retardance $\Gamma_C$ varies. Another result of variation in $\Delta n_A$ is variation in the average in-plane refractive index $n_{A,avg}$.

In general, the spatially varying tilt angle is created in a layer of LC material that is capable of forming an O-plate having two or more different tilt angles between 0 and 90 degrees. More specifically, the LC material is coated over a substrate, over the area of which, the tilt angle is made to vary either continuously, discretely, or randomly. While the tilt angle $\theta$ is varied across a surface of the LC material layer, the azimuthal angle $\phi$, may be uniform, or may also be made to vary either continuously or discretely, over the area of the LC material layer. In general, the spatially varying tilt angle refers to an average tilt angle that varies in a transverse direction along the surface of the substrate. More specifically, the tilt angle at each point on the surface will be an average of the LC directors across the thickness of the layer (i.e., the tilt angle typically will be higher closer to the alignment layer).

In one embodiment, the LC layer is formed from an O-plate type LCP precursor, the tilt angle of which is determined by experimental conditions. For example, in one embodiment the LCP precursor is ROF5106 LCP precursor available from Rolic. In other embodiment, the LC layer is formed from ROF5106 blended in various ratios with ROF5113 LCP precursor, also available from Rolic. Blended mixtures are advantageous because they readily allow for various ranges of tilt angles to be obtained. The O-plate type LCP precursors are employed in conjunction with an alignment layer material, which is first coated on to the substrate before depositing the LCP precursor layer. In general, the alignment layer material will exhibit a mechanism by which the tilt angle of the subsequently coated LCP precursor can be controlled. In one embodiment, the alignment layer is a linearly photopolymerizable (LPP) polymer, which upon irradiation of controlled doses of linearly polarized ultraviolet (LPUV) radiation at a non-zero angle of incidence (AOI), will induce a predetermined azimuthal orientation and a predetermined tilt angle in the subsequently coated LCP precursor layer. In the case of the LPP/LCP system described above, the predetermined tilt angle is achieved by controlling the LPUV energy dose. For example, in one embodiment , ROP119, available from Rolic is used to form the LPP layer and the LCP layer is formed from ROF5106 LCP precursor available from Rolic, or ROF5106 blended in various ratios with ROF5113 LCP precursor, also available from Rolic. The resulting LPP/LCP system has been show provide controlled tilt angle, within a range, in the LCP. Advantageously, this process is not highly sensitive to the exact AOI used, however, in general, the AOI will be substantially different from zero.

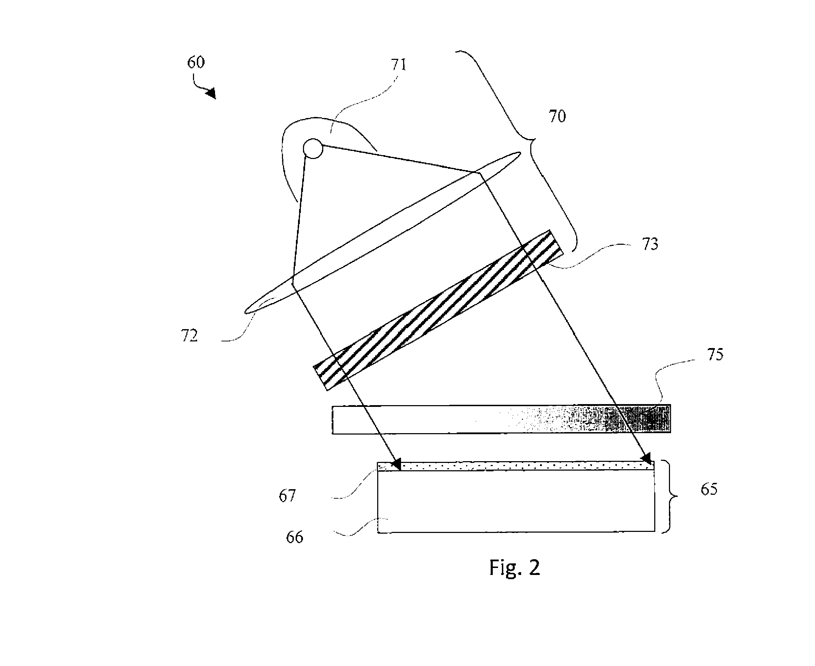

Referring to Fig. 2, there is shown a system for fabricating an optical element having an LC layer with a spatially-varying tilt angle. The optical setup **60** includes a mount for supporting the device under fabrication **65,** a linearly polarized ultra-violet (LPUV) light exposure system **70,** and a photo-mask **75.** The device under fabrication **65** includes a substrate **66** onto which a linear photo-polymerizable (LPP) alignment layer **67** is deposited. The LPUV exposure system **70** includes a UV light source **71,** a collimating lens **72,** and a UV polarizer **73.** Alternatively, the collimating lens **72** is replaced with a collimating reflector. The photo-mask **75** is patterned/designed to provide varying levels of light to the alignment layer in a predetermined manner. In particular, the photomask **75** is patterned to provide varying levels of energy density to the alignment layer as a function of transverse spatial coordinate. In one embodiment, the photomask **75** is a variable transmission mask. In another embodiment, the photomask **75** is a variable size aperture mask. In another embodiment, a series of binary masks are used individually to produce the effect of varying levels of energy density delivered to the alignment layer as a function of transverse spatial coordinate. In yet another embodiment, a combination of masked and maskless exposures are used to produce the effect of varying levels of energy density delivered to the alignment layer as a function of transverse spatial coordinate.

In operation, the light source **71** provides LPUV light at an oblique angle to the surface of the substrate **66.** In this embodiment, the light source is shown to be tilted relative to the horizontal substrate. In other embodiments, the substrate is tilted relative to the light source. The non-normal LPUV light incidence and its energy density dose induce a change in the alignment layer **67** that causes the LC director in a subsequently deposited LCP pre-cursor layer to be aligned at an oblique angle (tilted out of the plane of the substrate at some azimuthal angle). In this embodiment, the UV polarizer **73** is oriented to transmit, with high transmission, UV light polarized parallel to the plane of drawing (e.g., which is the plane of incidence). Depending on the chemistry of the LPP material, this configuration will typically result in the LC director of the subsequently deposited LCP layer to be aligned in an azimuthal plane that is parallel or orthogonal to the LPUV plane of incidence. The actual out-of-plane tilt of the LC director is dependent on the LPUV energy density dose delivered to the LPP alignment layer **67.** Since the photomask **75** provides various energy densities to the alignment layer **67** in a predetermined pattern, a subsequently formed LCP film having a spatially variable tilt angle, which has variable in-plane retardance, results. Although the out-of-plane tilt of the LC director varies in a predetermined manner across the film, in this embodiment the azimuthal angle of the LC directors is constant. Once the LPP layer is exposed to LPUV in this manner, then a thin layer of liquid crystal polymer precursor is coated on the alignment layer. This layer is then exposed to UV light (e.g., which does not have to be polarized) to cross-link the LCP precursor and fix the LC directors at the predetermined oblique angles. Accordingly, relatively stable LCP layers, which only need to be supported by a single substrate, are provided.

Note that this fabrication technique has been described with reference to an LCP precursor, which is preferably cross-linked with a subsequent UV irradiation to convert it to LCP. In general, the O-plate LCP layer may be formed using any of the LPP and O-plate LC compounds known in the art, the latter of which may be polymerized and/or cross-linked with UV irradiation and/or thermally. For example in one embodiment, the LPP layer is formed by spin-coating a 2 wt% solution of ROP119 in cyclopentanone on a glass substrate (e.g., for 60 seconds at 2000 RPM) to obtain a 50 nm thick alignment layer. In other embodiments, the LPP layer is formed using another coating method such as wire-coating, gravur-coating, slot-coating, etc. to coat the ROP119 layer. In general, the LPP will often include cinnamic acid derivatives and/or ferulic acid derivatives, as is well known in the art. In accordance with the instant invention, the LPP layer will be of the type to generate an out-of-plane tilt in the subsequently applied LC or LCP layers. In one embodiment, the LPP coated glass is baked on a hot plate for a predetermined time (e.g., 5 minutes) at a predetermined temperature (e.g., 180 degrees) before being LPUV irradiated through the photomask. In one embodiment, the LCP layer is formed from liquid crystalline material that includes a LCP precursor. LCP precursor materials, which for example may include a cross-linkable diacrylate nematic liquid crystalline compound, are well known in the art. In accordance with the instant invention, the LCP material will be of the type that will appropriately respond to the tilt inducing LPP layer. Various LCP precursor compounds suitable for forming the LCP layer are available from Rolic (Allschwil, CH). In one embodiment the LCP precursor layer is spin-coated on the LPP layer as a 15 wt% solution of ROF5106 LCP precursor, or a mixture of ROF5106 LCP precursor and ROF5113 LCP precursor, in anisole. In other embodiments, the LCP layers are formed using another coating method such as wire-coating, gravur-coating, slot-coating, etc. The resulting LPP/LCP device is then typically baked (i.e., annealed) for a predetermined time to promote good alignment of the LCP to the LPP alignment layer. Advantageously, the subsequent photochemical cross-linking of the LCP precursor to form LCP solidifies the film and makes permanent the orientations of the LC directors. This is believed to provide improved reliability under high power illumination and short wavelength laser exposure.

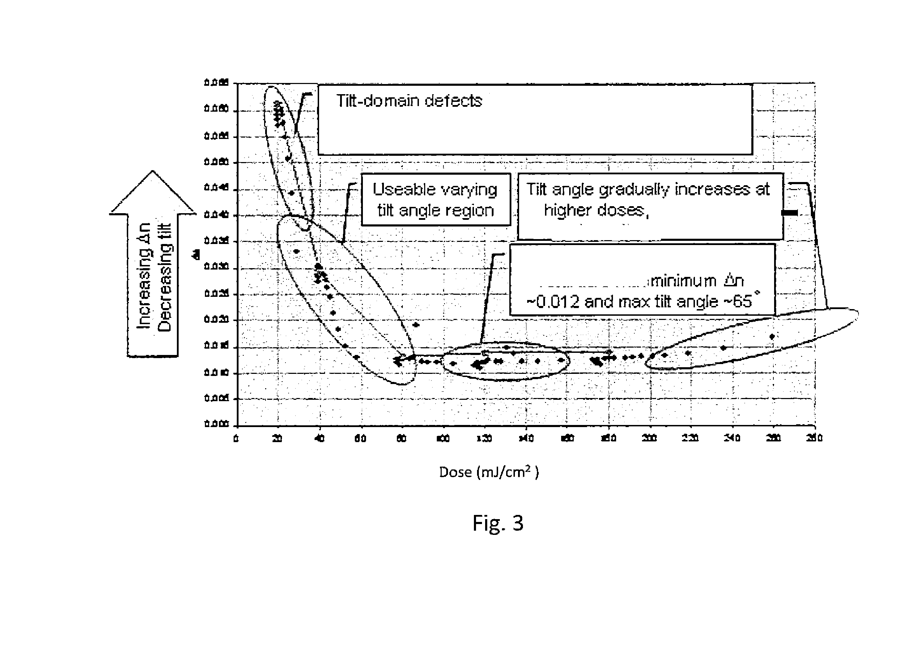

As discussed above, one method of controlling the tilt imposed by the LPP layer is to alter the LPUV dose on the LPP layer. Referring to Fig. 3, there is shown a plot of $\Delta n_A$ response versus LPUV dose, applied an angle of incidence of 40 degrees, for the ROP119/ROF5106 LPP/LCP system discussed above. For LPUV doses less than ~80 mJ/cm$^2$ there is a high rate of change in tilt angle and $\Delta n_A$. For LPUV doses greater than ~180mJ/cm$^2$ there is a gradual change in tilt and $\Delta n_A$. At low doses, below ~40 mJ/cm$^2$ various tilt-domain defects are observed in this system. More specifically, "low tilt-domains", which appear somewhat as isolated phase-separated domains, within a matrix LCP phase, having distinctly different tilt than the matrix LCP, are observed. In accordance with one embodiment of the instant invention, these observations are used to produce birefringent optical elements having a spatially varying or patterned tilt angle (e.g., and thus and $\Delta n_A$, $\Gamma_A$, $\Gamma_C$, $n_{A,av}$). The spatial variations may be discrete or continuous, macroscopic in scale, or microscopic in scale.

In accordance with one embodiment of the instant invention, a LPUV dose pattern is established by exposing the LPP layer through a series of one or more individual photomasks. More specifically, the spatially modulated LPUV dose is applied as a range of doses or as two or more discrete doses via one or more photomasks, or via a combination of masked and maskless exposures.

For example, in one embodiment a spatially varying tilt is provided in the ROP119/ROF5106 LPP/LCP system discussed above, by irradiating the LPP layer using a two step process. In the first step, the layer is exposed to linearly polarized light without the photomask (e.g., through a standard aperture, to set the lowest tilt-angle at all locations). In a second step, the layer is exposed to the linearly polarized light through the photomask (e.g., to set the higher tilt-angles at select locations corresponding to the transmitting areas of the photomask). In this embodiment, the total energy density (i.e. dose) delivered will be higher at those regions exposed in the first and second irradiation steps, as compared to those regions only exposed in the first irradiation step. In general, the required energy density and wavelength of illumination will be dependent on the LPP material. For the ROP119/ROF5106 LPP/LCP system discussed above, the energy density will be typically between 30 - 300 mJ/cm2, while the wavelength range will be typically between 280 and 365 nm. The incident angle of LPUV will be typically between 20 and 60 degrees. Notably, the angle of incidence (AOI) has not been found to have a significant effect on the process, however, in general, the AOI should be substantially different from zero.

In this embodiment, the photomask has a first plurality of regions that block the LPUV and a second plurality of regions that transmit the LPUV (i.e. a binary mask). Since the total dose delivered at any given point on the LPP layer is the sum of the doses delivered to that point in each of the exposures (e.g., if the azimuthal orientation of the LPUV is the same for all exposures), the LPP will induce a spatially varying tilt angle in the subsequently applied LC layer, wherein the spatially varying tilt angle is arranged in a discrete pattern dictated by the photomask. For example, in one embodiment, the spatially varying tilt angle provides an alternating in-plane retardance pattern (e.g., corresponding to the tilt angle pattern illustrated in Fig. 1c).

In general, the photomask will be patterned in dependence upon the intended application. In one embodiment, the photomask is patterned to provide varying energy densities to the alignment layer in a pixelated manner. In general, the pixels will be periodic (e.g., at regular intervals) or non-periodic (e.g., random or in a predetermined pattern). Advantageously, the use of the photomask allows the LCP layer to be patterned with a large number of phase profile levels and with increased precision. In one embodiment, the photomask is patterned to provide two levels of phase profile. In another embodiment, the photomask is patterned to provide more than two levels of phase profile. In general, if the LC having the spatially varying tilt angle is a diffraction grating or more complicated hologram, it will have typically at least 4 levels of phase profile in order provide reasonable diffraction efficiency.

In another embodiment, the spatially varying tilt is provided in the ROP1191ROF5106 LPP/LCP system discussed above, by irradiating the LPP layer through a single photomask. In this embodiment, the photomask is a gradient mask having an optical density profile that provides a spatially varying LPUV dose that is continuously varied, rather than discretely varied. For example, in one embodiment, the spatially varying tilt angle forms a continuously varying gradient (e.g., the retardance pattern illustrated in Fig. 1d).

In each of these embodiments, the optic axis of the LC director has a spatially varying tilt angle and a substantially uniform azimuthal angle. In other embodiments, the LPP layer is irradiated a plurality of times, each time with the LPUV having a different azimuthal orientation. For example, in one embodiment, the azimuthal orientation of the LPUV differs among the various exposures delivered to different points on the LPP layer, such that a superimposed pattern of spatially varying tilt angles and azimuthal orientations is provided in the LCP layer. In this case, the prediction of the resulting tilt angle and in-plane orientation of the LCP is more complicated.

In addition, in each of the above described embodiments, the substrate is optionally provided with a non-reflective back surface, which is non-reflecting for the UV wavelengths for which the LPP material responds. For example, in one embodiment the back surface of the substrate is coated with a UV anti-reflection coating or a UV absorbing coating. Advantageously, the non-reflective coating prevents strong back reflections of LPUV from the back surface of a UV transparent substrate, which can tend to degrade the dose pattern. Notably, this is more of an issue if the photomask employed contains a microscopic or relatively small-featured pattern, where it is more difficult to realize the expected tilt angle pattern. In other embodiments, where the intrinsic reflectivity of the substrate material is sufficiently low, or where the substrate is non-transmissive to UV, a non-UV-reflective back surface is typically not needed for the LPUV process.

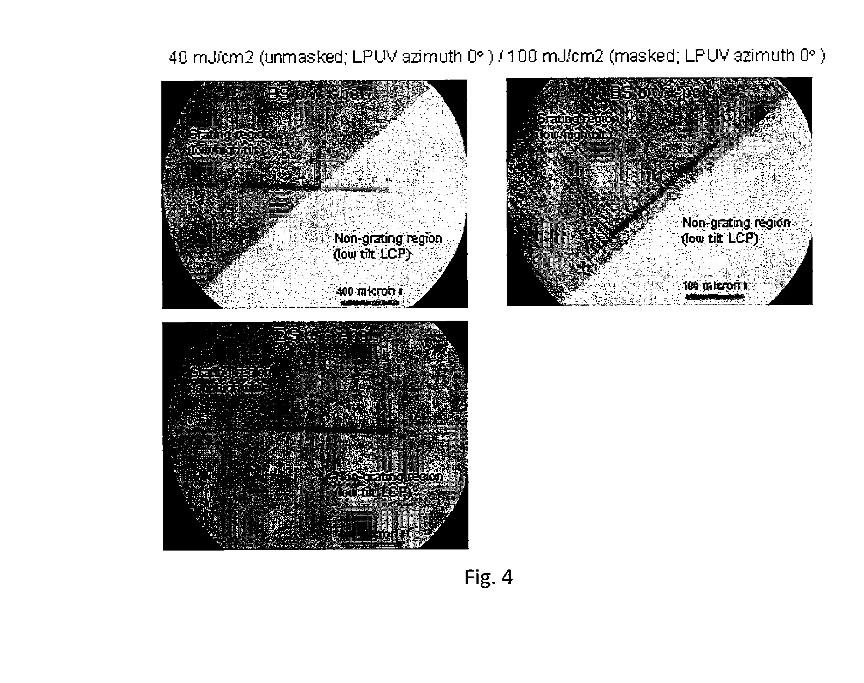

Referring to Fig. 4, there is shown an example of a microscopically patterned tilt angle structure. More specifically, the photos show images wherein the structure includes a first area having a spatially varying tilt angle (i.e., labelled the grating region) and a second area having a uniform tilt angle (i.e., labelled the non-grating region). The upper photos are bright-state (BS) images with the sample being viewed in transmission between crossed polarizers, whereas the lower photo is a dark state (DS) image with the sample being viewed in transmission between crossed polarizers.

The spatially varying tilt angle LCP structure was formed by spin-coating a LPP layer including a 2 wt% solution of ROP119 in cyclopentanone on a 200 mm fused silica substrate wafer (e.g., for 60 seconds at 2000 RPM) to obtain a 50 nm thick alignment layer. In this embodiment, no anti-reflection coating was provided on the substrate. The LPP coated substrate was then subject to a two-step irradiation process. In the first step, the layer was exposed in a first exposure to LPUV without the photomask to set the lowest tilt-angle at all locations. More specifically, this first LPUV exposure provides a uniform low dose (i.e., 40mJ/cm$^2$) corresponding to the lower tilt angle. In the second step, the grating region is exposed in a second exposure to the LPUV light through a grating photomask having 5$\mu$m lines/5$\mu$m spaces to set the higher tilt-angles at select locations corresponding to the transmitting areas (the 5$\mu$m spaces) of the photomask. More specifically, the second LPUV exposure provides a patterned high dose (i.e., 100 mJ/cm$^2$) such that the sum of the first low dose exposure and the second high dose exposure correspond to the high tilt angle generated at locations corresponding to the transmitting areas of the photomask. For both exposures, the azimuthal angle of the LPUV light was the same measured relative to some arbitrary reference (in this case, the azimuthal angle was nominally parallel to the grating direction). For both exposures the incident angle of LPUV was 40 degrees. Subsequently, an LCP layer was formed by spin-coating a 37% wt% solution of ROF5106 LCP precursor on the LPP layer (i.e., at 1000 rpm). The LC directors in the LCP layer adopted a tilt angle pattern defined by the patterned LPUV exposure doses. The LCP precursor layer was subsequently annealed, UV cured to form LCP, post-baked.

The resulting LCP layer included a grating having 5 micron wide lines, alternating in tilt angle. Mores specifically, the grating included a pattern of alternating lines of high and low retardance, due to LCP tilt angle alternating between ~50° and ~65° (i.e., corresponding to the retardance alternating between 75~80 nm and 25 nm, respectively). The grating direction is parallel to the tilt plane of both tilt angles.

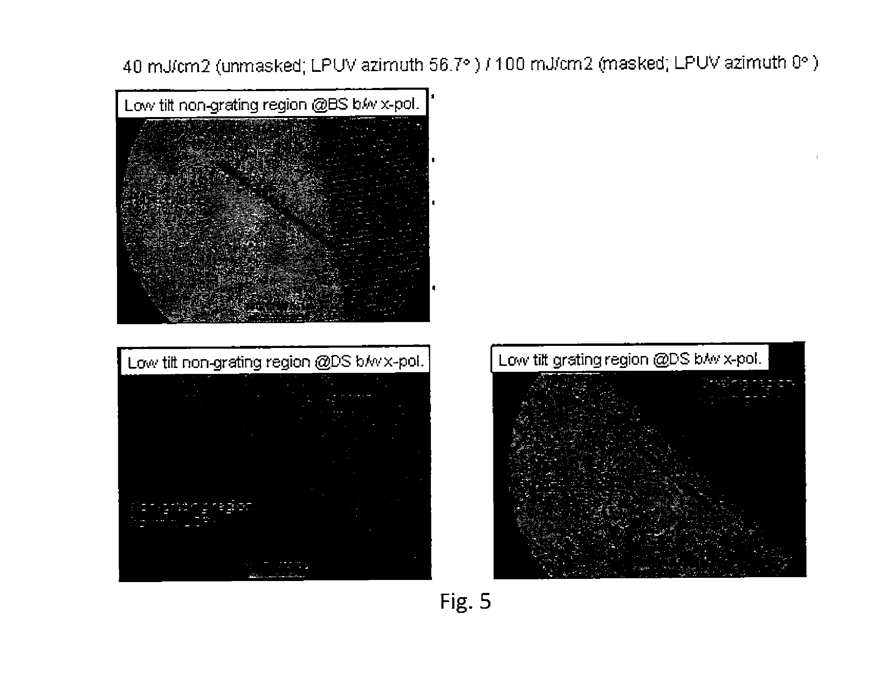

Referring to Fig. 5, there is shown another example of a microscopically patterned tilt angle structure. More specifically, the photos show images wherein the structure includes a first area having a spatially varying tilt angle (i.e., labelled the grating region) and a second area having a uniform tilt angle (i.e., labelled the non-grating region). The upper photo is a BS image with the sample being viewed in transmission between crossed polarizers, whereas the lower photos are DS images with the sample being viewed in transmission between crossed polarizers.

The spatially varying tilt angle LCP structure was formed by spin-coating a LPP layer including a 2 wt% solution of ROP119 in cyclopentanone on a 200 mm fused silica substrate wafer (e.g., for 60 seconds at 2000 RPM) to obtain a 50 nm thick alignment layer. In this embodiment, no anti-reflection coating was provided on the substrate. The LPP coated substrate was then subject to a two step irradiation process. In the first step, the LPP layer was exposed in a first exposure to LPUV without the photomask (e.g., through a standard aperture, to set the lowest tilt-angle at all locations). More specifically, this first LPUV exposure provides a uniform low dose (i.e., 40mJ/cm$^2$) corresponding to the lower tilt angle. In the second step, the grating region is exposed in a second exposure to the LPUV light through a grating photomask having 5$\mu$m lines/5$\mu$m spaces to set the higher tilt-angles at select locations corresponding to the transmitting areas (the 5$\mu$m spaces ) of the photomask. More specifically, the second LPUV exposure provides a patterned high dose (i.e., 100 mJ/cm$^2$) such that the sum of the first low dose exposure and the second high dose exposure correspond to the high tilt angle generated at locations corresponding to the transmitting areas of the photomask. For the first exposure, the azimuthal angle of the LPUV light was 56.7 degrees. For the second exposure, the azimuthal angle of the LPUV light was 0 degrees. For both exposures the incident angle of LPUV was 40 degrees. Subsequently, an LCP layer was formed by spin-coating a 37% wt% solution of ROF5106 LCP precursor on the LPP layer (i.e., at 1000 rpm). The LC directors in the LCP layer adopted the tilt angle pattern and azimuthal angle pattern defined by the patterned exposure doses and azimuthal angles of the LPUV. The LCP precursor layer was subsequently annealed, UV cured to form LCP, post-baked.

The resulting LCP layer included a grating of high/low tilt lines with a slow axis (SA) azimuthal offset between lines. In particular, the high/low tilt lines exhibited an approximately 45 degree SA offset. More specifically, the 45 degree SA offset was observed based on the resulting low tilt SA being approximately 57 degrees from grating direction, and the resulting high tilt SA being approximately 14 degrees from grating direction. Notably, the SA offset between high/low tilt grating lines appears to be less than offset of the azimuthal angles of the first and second LPUV exposures. This is due to the fact that the high tilt regions defined by the second exposure actually receive two different LPUV exposure doses with different azimuthal angles.

In accordance with another embodiment of the instant invention, a LPUV dose pattern is established by exposing the LPP layer to LPUV while the LPP layer is translated in a single direction. More specifically, the moving LPP layer is exposed through a stationary aperture and/or mask, or series of apertures and/or masks, interposed between the LPP layer and the LPUV source. As a result, an LPUV dose pattern is established along one direction of the substrate surface, while being substantially constant along another direction.

For example, in one embodiment a spatially varying tilt is provided in the ROP119/ROF5106 LPP/LCP system discussed above, by irradiating the LPP layer using a two step process. In the first step, the stationary LPP layer is uniformly exposed to a low dose of linearly polarized light through a regular aperture. In a second step, the LPP layer is exposed to a higher dose of linearly polarized light through a sawtooth photomask while the LPP layer is translated in a first direction. In this embodiment, the energy density (i.e. dose) will vary in a predetermined continuous manner. More specifically, LPUV dose delivered to each point on the LPP layer is determined by the product of exposure time and LPUV power. The exposure time is a function of the translation velocity of the substrate and the width of the aperture. The LPUV power is a function of the transmission of the aperture opening. In general, the required energy density and wavelength of illumination will be dependent on the LPP material. For the ROP119/ROF5106 LPP/LCP system discussed above, the energy density will be typically between 30 - 300 mJ/cm2, while the wavelength range will be typically between 280 and 365 nm. The incident angle of LPUV will be typically between 20 and 60 degrees. The translation velocity and the width of the sawtooth aperture needed to achieve a desired dose are dependent upon the power output of the polarized UV light source.

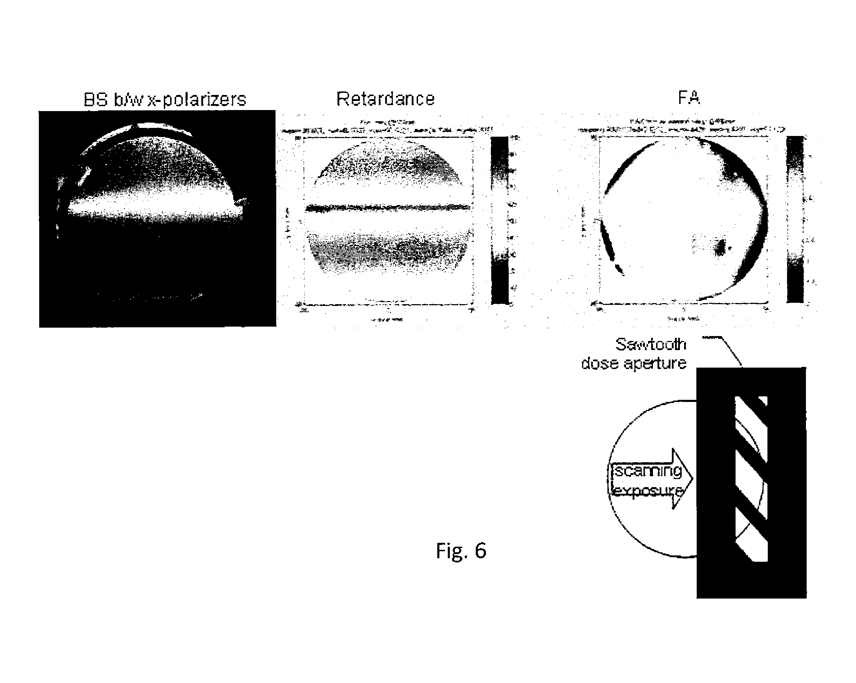

Referring to Fig. 6 there is shown an example of a macroscopic continuously varied tilt angle structure produced on a 200 mm glass substrate. More specifically, the left side of Fig. 6 shows a BS image of the structure viewed between crossed polarizers, the middle plot shows the spatially varying retardance, and the right side shows the azimuthal direction of the FA axis to be substantially uniform. Also shown in the bottom right of the figure is the sawtooth photomask.

The spatially varying tilt angle LCP structure was formed by spin-coating a LPP layer including a 2 wt% solution of ROP119 in cyclopentanone on a 200 mm fused silica substrate wafer (e.g., for 60 seconds at 2000 RPM) to obtain a 50 nm thick alignment layer. In this embodiment, no anti-reflection coating was provided on the substrate. The LPP coated substrate was then subject to a two step irradiation process where the LPP coated substrate was exposed through certain apertures in a translation scanning manner. In the first step, the layer was exposed in a first exposure to LPUV through a parallel aperture, scanning in a single direction at a constant speed to provide a uniform dose of 40mJ/cm$^2$ at all locations. In the second step, the layer was exposed in a second exposure to LPUV through a sawtooth dose aperture (e.g., as illustrated in Fig. 6), scanning in the same direction as in the first exposure at a constant speed to produce a periodically varying dose from 0 to 60 mJ/cm$^2$ in the direction perpendicular to the scanning direction. More specifically, resulting from this two step exposure process, the LPP layer receives an oscillating LPUV dose from 40 to 100 mJ/cm$^2$ across the surface of the LPP layer in the direction perpendicular to the scanning direction. For both exposures, the azimuthal angle of the LPUV light was 0 degrees. For both exposures the incident angle of LPUV was 40 degrees. Subsequently, an LCP layer was formed by spin-coating a 37% wt% solution of ROF5106 LCP precursor on the LPP layer (i.e., at 1000 rpm). The LC directors in the LCP layer adopted a tilt angle pattern defined by the patterned LPUV exposure doses. The LCP precursor layer was subsequently annealed, UV cured to form LCP, post-baked.

The resulting LCP layer has an in-plane retardance value that varies in a sawtooth pattern in one direction on the substrate. More specifically, the roughly linearly varying retardance varies between approximately 25 to 85 nm, due to the tilt angle varying between 65 and 50 degrees (i.e., corresponding to a Δn range of 0.012 and 0.04).

In the above describe embodiment, the substrate was translated in a direction perpendicular to the azimuthal angle of the LPUV, which produced a FA in the LCP layer that was parallel to the translation direction and constant. In other embodiments, the LPUV azimuthal orientation is rotated during the second exposure in order to make the FA azimuthal orientation of an LCP layer vary spatially. In yet other embodiments, the LPP layer is rotated rather than translated.

For example, in one embodiment a spatially varying tilt is provided in the ROP119/ROF5106 LPP/LCP system discussed above, by irradiating the LPP layer using a two step process. In the first step, the stationary LPP layer is exposed in a first exposure to a low dose of linearly polarized light through a first stationary narrow arc-shaped aperture (i.e. with a vertex angle of only a few degrees) while the substrate is rotated 360 degrees from a starting position about an axis normal to its surface and coincident with the vertex of the aperture. In a second step, the LPP layer is exposed in a second exposure to a higher dose of linearly polarized light through a second stationary narrow arc-shaped aperture (i.e. with a vertex angle of only a few degrees), whose transmission varies in the radial direction from its vertex, while the substrate is rotated 360 degrees from the same starting position about an axis normal to its surface and coincident with the vertex of the aperture and also coincident with the rotation axis of the first exposure. In both exposures the apertures are placed in the same location relative to the starting position of the substrate, and the azimuthal angle of the LPUV illumination is the same relative starting position of the substrate. The dose delivered to each point on the LPP layer is still the product of exposure time and LPUV power, however, the exposure time is a function of the angular velocity of the substrate and the angular width of the aperture. The LPUV power remains a function of the transmission of the aperture opening. In general, the required energy density and wavelength of illumination will be dependent on the LPP material. For the ROP119/ROF5106 LPP/LCP system discussed above, the energy density will be typically between 30 - 300 mJ/cm2, while the wavelength range will be typically between 280 and 365 nm. The incident angle of LPUV will be typically between 20 and 60 degrees. The rotational velocity needed is dependent upon the desired dose, the LPUV power, and the angular width of the aperture opening. The combined effect of the two exposures provides a dose that, with respect to the substrate, varies radially from the point corresponding to the apertures' vertex locations, and is constant in the azimuthal direction about the point. Also, in the azimuthal direction relative to the substrate, about that point the LPUV's orientation varies by 1 degree per 1 degree of change in azimuthal location. Subsequently, an LCP layer was formed by spin-coating a 37% wt% solution of ROF5106 LCP precursor on the LPP layer (i.e., at 1000 rpm). The LC directors in the LCP layer adopted a tilt angle pattern defined by the patterned LPUV exposure doses. The LCP precursor layer was subsequently annealed, UV cured to form LCP, post-baked. In this embodiment, the LC directors of the LCP adopt a vortex azimuthal alignment (order m=2) about a point on the substrate, but also adopt a tilt angle that varies in the radial direction from the point.

In the above describe embodiments, wherein the substrate and/or LPUV light is altered (e.g., translated, rotated, etc.), the LPP layer is optionally subject to more than one of the variations discussed above. For example, in one embodiment, more than one high dose rotational exposure of the LPP is made, wherein the center of rotation differs between exposures. In another embodiment, both the LPP layer and the LPUV orientation relative to the substrate is varied during the rotational exposure process. In other embodiments, the LPP layer is exposed a plurality of times, each time with a different photomask and/or aperture. In the latter instance, one or more translation directions are optionally employed, in which a rotational orientation of the substrate in the plane of the substrate is made prior to each translation, and in which the LPUV orientation is optionally rotated prior to each translation. In effect, a complex 2-dimentional dose and azimuthal orientation pattern is readily realized.

In each of the above-described embodiments, wherein the substrate and/or LPUV light source is altered, the translation velocity, angular velocity, and LPUV source are constant. In other embodiments, the translational velocity or angular velocity is modulated while the substrate is being translated or rotated. In yet other embodiments, the LPUV source power is modulated during the translation or rotation process.

In each of the above-described embodiments, wherein the substrate and/or LPUV light source is altered, the photomask has one or more sections that allow LPUV to pass through to the LPP layer, completely block LPUV, and/or that allow a fraction of the LPUV to pass through to the LPP layer. For example, in one embodiment the photomask is a plate fabricated from a UV-blocking material (i.e., a metal plate) having an aperture. In one embodiment, the aperture has an opening profile that varies (modulates) in width measured in the direction that is parallel to the substrate's translation direction. In another embodiment, the aperture has sections that are completely blocked. In yet another embodiment, the aperture opening has a varying optical transmission (e.g., if a gradient optical density photomask is used as the photomask).

Advantageously, the above-described embodiments based on a stationary photomask and a stationary substrate are particularly useful for producing complex and finely patterned tilt angle structures, while the above-described embodiments based on a mechanically actuated substrate and/or LPUV light source are particularly useful for producing less complex and macroscopic tilt angle structures.

In accordance with another embodiment of the instant invention, a spatially varying tilt angle is established by exposing the LPP layer with a relatively low LPUV dose (i.e., below ~40 mJ/cm$^2$). Optionally, the low LPUV dose is provided through a series of one or more individual photomasks, as a range of doses or as two or more discrete doses.

As indicated in Fig. 3, for the LPP/LCP system described above, irradiating the LPP layer with a low LPUV dose (i.e., below ~40 mJ/cm$^2$ and particularly below 30 mJ/cm$^2$), will result in the formation of microscopic low tilt-domains (LTD) in the subsequently applied LCP layer. The term LTD refers to regions having a relatively low tilt angle compared to the surrounding LCP material. More specifically, the LTD appear somewhat as isolated phase-separated domains, within a surrounding "normal behaving" higher tilt LCP phase. Since the LTD have a distinctly lower tilt, they exhibit higher in-plane retardance (or birefringence) than the surrounding material. Since the spatial distribution of the LTD is typically random within the LCP layer, the result is a binary (or nearly binary) spatially varying tilt angle with a random distribution. In general, the size and area density of the LTD will increase as the LPUV dose is decreased. At some point, if the dose is sufficiently low, a continuous network of LTD is expected.

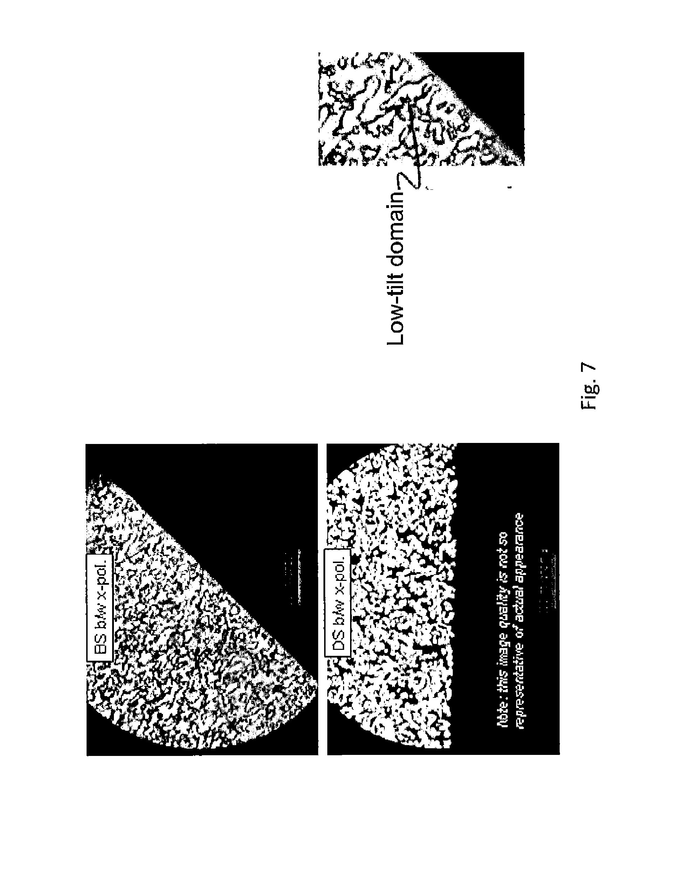

Referring to Fig. 7, there is shown an example of the microscopic LTD formed using the LPP/LCP system described above with a single exposure at 20 mJ/cm$^2$. More specifically, the photos show images wherein the structure includes a first area having a spatially varying tilt angle (i.e., the upper regions showing the LTD) and a second area have a uniform tilt angle (i.e., the lower area). The upper photo is a BS image with the sample being viewed between crossed polarizers, whereas the lower photo is a DS image with the sample being viewed between crossed polarizers. The lower right photo shows a close-up of the LTD in the BS image with the sample being viewed between crossed polarizers.

The spatially varying tilt angle LCP structure was formed by spin-coating a LPP layer including a 2 wt% solution of ROP119 in cyclopentanone on a 200 mm fused silica substrate wafer (e.g., for 60 seconds at 2000 RPM) to obtain a 50 nm thick alignment layer. In this embodiment, no anti-reflection coating was provided on the substrate. The LPP coated substrate was first exposed in a first exposure to LPUV at relatively low uniform dose of 20mJ/cm$^2$. The lower portion of the LPP coated substrate only was then exposed in a second exposure to an LPUV dose of 100 mJ/cm$^2$ (i.e., for a total dose of 120 mJ/cm$^2$). The azimuthal angle of the LPUV light was 0 in each case. Subsequently, an LCP layer was formed by spin-coating a 37% wt% solution of ROF5106 LCP precursor on the LPP layer (i.e., at 1000 rpm). The LCP precursor layer was subsequently annealed, UV cured to form LCP, post-baked.

The resulting LCP layer has a spatially varying in-plane retardance. In particular, the lower region will have a uniform retardance corresponding to the relatively high-tilt angle, whereas the upper region has a binary spatially varying retardance. More specifically, the in-plane retardance value spatially varies across a surface of the substrate in a random binary fashion. Referring to Fig. 7, the binary spatially varying tilt angle results from the formation of the LTD (i.e., the brighter phase in the BS images). Notably, the LTD are separated from the main LC matrix via a disclination line (i.e., the darker line that boarders the lower tilt phase). In general, the two phases will exhibit the same slow axis (SA) orientation, although, the exact tilt angle and in-plane birefringence has not been measured.

Advantageously, this embodiment provides a random spatial distribution of two discrete LCP tilts angles (i.e., one from the LTD and one from the "normal" behaving LCP) using a single exposure. In general, the relative size and area density of the LTD within the LCP layer depends on the exposure dose, and may depend by other processing conditions.

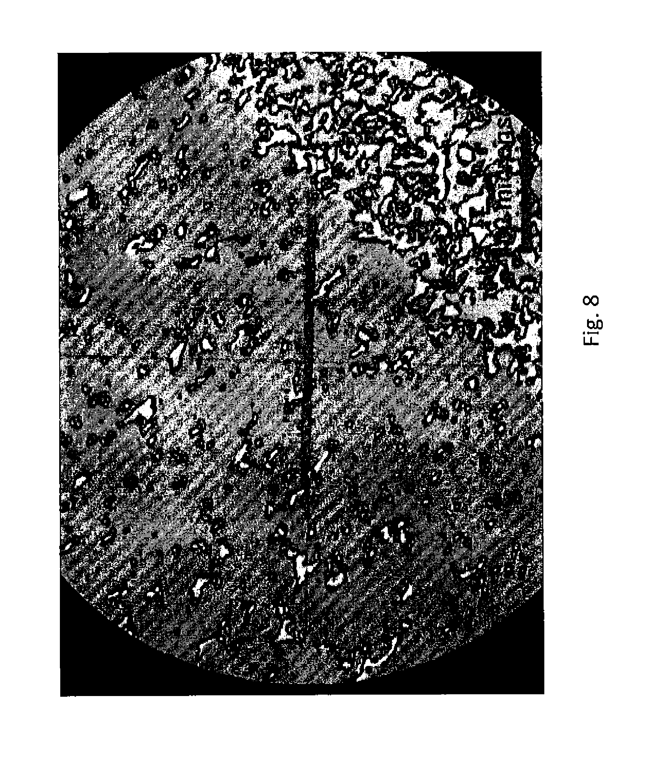

In the embodiment discussed with reference to Fig. 7, the spatially varying spatially varying tilt angle was achieved with a single exposure. In other embodiments, the formation of LTD with sufficiently low dose LPUV light is combined with any of the above described embodiments. For example, referring to Fig. 8, there is shown an example of the microscopic LTD formed using a method similar to that used to form the structure illustrated in Fig. 4.

More specifically, the spatially varying tilt angle LCP structure was formed by spin-coating a LPP layer including a 2 wt% solution of ROP119 in cyclopentanone on a 200 mm fused silica substrate wafer (e.g., for 60 seconds at 2000 RPM) to obtain a 50 nm thick alignment layer. In this embodiment, no anti-reflection coating was provided on the substrate. The LPP coated substrate was then subject to a two step irradiation process. In the first step, the layer was exposed in a first exposure to LPUV without a photomask to set the lowest tilt-angle at all locations. More specifically, this first LPUV exposure provides a uniform low dose (i.e., 20mJ/cm$^2$) corresponding to the lower tilt angle. In the second step, the upper portion is exposed in a second exposure to the LPUV light through a grating photomask having 5$\mu$m lines/5$\mu$m spaces to set the higher tilt-angles at select locations corresponding to the transmitting areas (the 5$\mu$m spaces )of the photomask. More specifically, the second LPUV exposure provides a patterned high dose (i.e., 100 mJ/cm$^2$) such that the sum of the first low dose exposure and the second high dose exposure correspond to the high tilt angle generated at locations corresponding to the transmitting areas of the photomask. For both exposures, the azimuthal angle of the LPUV light was the same measured relative to some arbitrary reference (in this case, the azimuthal angle was nominally parallel to the grating direction). Subsequently, an LCP layer was formed by spin-coating a 37% wt% solution of ROF5106 LCP precursor on the LPP layer (i.e., at 1000 rpm). The LC directors in the LCP layer adopted a tilt angle pattern defined by the patterned LPUV exposure doses. The LCP precursor layer was subsequently annealed, UV cured to form LCP, post-baked.

The resulting LCP layer included an upper area having a grating with 5 micron wide lines, alternating in tilt angle (e.g., corresponding to alternating doses of 20 and 120 mJ/cm$^2$), and a lower area with randomly distributed LTD (e.g., corresponding to a single dose of 20 mJ/cm$^2$). Referring to Fig. 8, the darker grating lines correspond to the 120 mJ/cm$^2$ dose, and therefore have the highest tilt, whereas the brighter grating lines correspond to the 20 mJ/cm$^2$ dose, and thus have a lower tilt than the 120 mJ/cm$^2$ dose lines. Notably, the LTD appear to preferentially form on the low dose grating lines. In particular, it is evident that smaller-sized LTD have nucleated only on the brighter 20 mJ/cm$^2$ dose lines. Some larger-sized LTD, however, have been found to bridge across 120 mJ/cm$^2$ lines, between two or more 20 mJ/cm$^2$ dose lines.

Advantageously, LCP layers exhibiting the LTD bridging effect have potential in applications where a pseudo-random distribution of three or more LCP tilt angles is required, and/or where the range of available tilt angles without LTD is insufficient. For example, in one embodiment an LPP layer is exposed to a pattern of alternating small features, for example as in a microscopic checker-board pattern, where the alternating features are alternately exposed to high and low LPUV doses. In this case, the process is optimized to cause LTD to randomly nucleate on some proportion of the low dose features, and for some of those LTD to bridge to other nearby low dose features.

In other embodiments, LTD bridging is reduced and/or eliminated by increasing the width of the high dose features, increasing the width of the low dose features, or increasing the dose applied to the low dose lines in order to decrease the size and area density of the LTD.

Many applications for LCP layers having spatially varying tilt angle, and in particular, having LTD, are envisioned. For example, in one embodiment, an LCP layer having a spatially varying tilt angle is used to reduce speckle in a laser illumination system.

Laser illumination systems are commonly used in projection displays to provide high power illumination and saturated color. However, while lasers provide bright images with good color, the image quality can be degraded due to speckle. Speckle arises when coherent light is reflected from a rough or dusty surface, or propagates through a medium with random refractive index variations. More specifically, it arises when the reflected light, which includes multiple beams with differential delays greater than the wavelength of light, interfere at the detector (e.g. human eye, or square law photodetector). This interference provides an uneven, random, fluctuation of light intensity commonly referred to as a speckle pattern.

In projection displays, speckle generally originates when the light reflects off of the display screen, which typically has a surface roughness greater than one quarter of the wavelength of the laser light. The resulting random spatial interference of the reflected laser light produces a speckle pattern that significantly degrades the quality of the image (e.g., making it appear grainy and/or less sharp). In addition, depending on the view point, the speckle pattern may change due to the different characteristics of relative phase delays in a given direction. As a result, the image being observed changes with view point and the optical system fails to reliably recreate a high fidelity image.

While refractive index variation, dust on optical components, and screen roughness all cause speckle, the effect is typically only a significant problem when a coherent light source, such as a laser, is used. There are several ways to reduce/destroy the coherence of the laser output so that the display is not susceptible to image quality degradation. One approach is to increase the number of longitudinal modes, so that the speckle patterns from multiple wavelengths average to a smooth profile. Another approach is to tile an array of coherent laser diodes (LD), which provides for a spatially incoherent illumination. Unfortunately, this provision of wavelength diversity is an expensive approach (i.e., many miniature projectors typically rely on a single LD chip to output tens of lumens illumination). Yet another approach is to create polarization diversity in the laser illumination. For example, one laser beam can be split into two polarizations, with the first polarization being allowed through a PBS and a second polarization delayed by greater than the coherence length of the laser. Unfortunately, this approach is bulky and has limited speckle contrast reduction.

Apart from changing the laser diode (LD) arrangement (i.e., decreasing spatial coherence) or manipulating the laser device characteristics (i.e., providing polarization and wavelength diversities) to reduce the spatial and temporal coherence of the laser beam, an alternate approach is to create many small grains of varied boiling speckle patterns which shift through the XY plane in time and allow for temporal averaging for the detector (i.e., eye) to reduce intensity non-uniformity. This approach typically requires an external optical element, such as a diffuser [J.W. Goodman et al., "Speckle reduction by a moving diffuser in laser projection displays," Annual Meeting of the Optical Society of America, Rhode Island, 2000], a phase plate [US patent Nos. 6,323,984 and 06747781], or a random diffractive optical element [L. Wang et al., Speckle reduction in laser projection systems by diffractive optical element," Appl. Opt. 37, pp. 177-1775, 1998], which are vibrated or spun to yield multiple phase delays for each XY site over time.

In US Pat. Appl. No. 12/424,168, for Retarder-based Despeckle Device for Laser Illumination Systems, Tan et al. propose another approach to creating many varied boiling speckle patterns using an actuatable waveplate element. In particular, the actuatable waveplate element produces the varied speckle patterns by providing a variable phase modulation generated by the mechanical agitation and/or electronic switching of a near half-wave optical retarder, which has a spatially varied slow axis orientation including a plurality of vortices (i.e., the tilt angle is constant, but the azimuthal angle varies across the surface of the retarder).

In accordance with one embodiment of the instant invention, the LCP layer having a spatially varying tilt angle is used to create a random phase diffuser used to reduce speckle in laser projection systems.

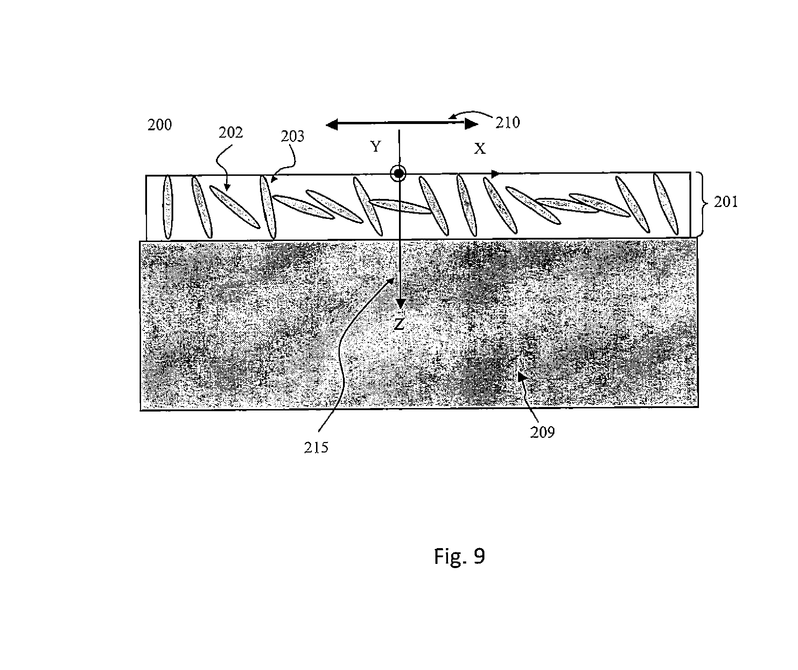

Referring to Fig. 9, there is shown an example of a randomly tilted liquid crystal device forming the random phase diffuser. The device 200 includes a variable tilt LC layer 201 disposed on a substrate 209. The LC layer 201 includes a plurality of differently tilted directors, two of which are shown as 202 and 203. For illustrative purposes, the LC layer 201 is shown parallel to the XY plane, while the incident light propagates parallel to the the Z-axis 215. The plane of tilt for the LC molecules is parallel to XZ plane. The input linear polarization 210 is aligned to the plane of tilt.

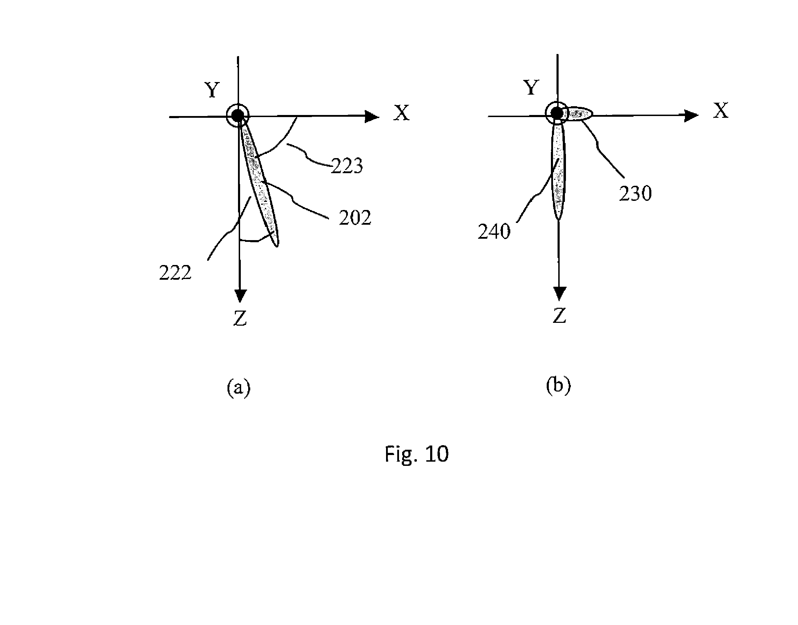

Without loss of generality, a single encoding element is represented by an LC director inclined at an angle with respect to the Z-axis and contained within the XZ plane. Referring to Fig. 10, the birefringence of this LC director, which has uniaxial O-plate birefringence as shown in (a), can be projected into in-plane and out-of-plane birefringence components as shown in (b). More specifically, the LC director 202 forms a polar angle offset 222 $\theta_c$ with the Z-axis, whereas the out-of-plane tilt 223 $\theta_t$ is given by $\pi/2-\theta_c$. In the extreme cases, the LC alignment has A-plate symmetry ($\theta_t=0$ degrees) or C-plate symmetry ($\theta_t=90$ degrees). From the quadratic equations describing the index ellipsoid, the in-plane $n_a$ and out-of-plane $n_c$ effective indices are represented by the projection onto the XY-plane 230 and projection along the Z-axis 240. These effective indices are given by,

$$\frac{1}{[n_A(\theta_t;\lambda)]^2} = \frac{\cos^2(\theta_t)}{[n_e(\lambda)]^2} + \frac{\sin^2(\theta_t)}{[n_o(\lambda)]^2} \text{, and} \tag{1}$$

$$\frac{1}{[n_C(\theta_t;\lambda)]^2} = \frac{\sin^2(\theta_t)}{[n_e(\lambda)]^2} + \frac{\cos^2(\theta_t)}{[n_o(\lambda)]^2}, \tag{2}$$

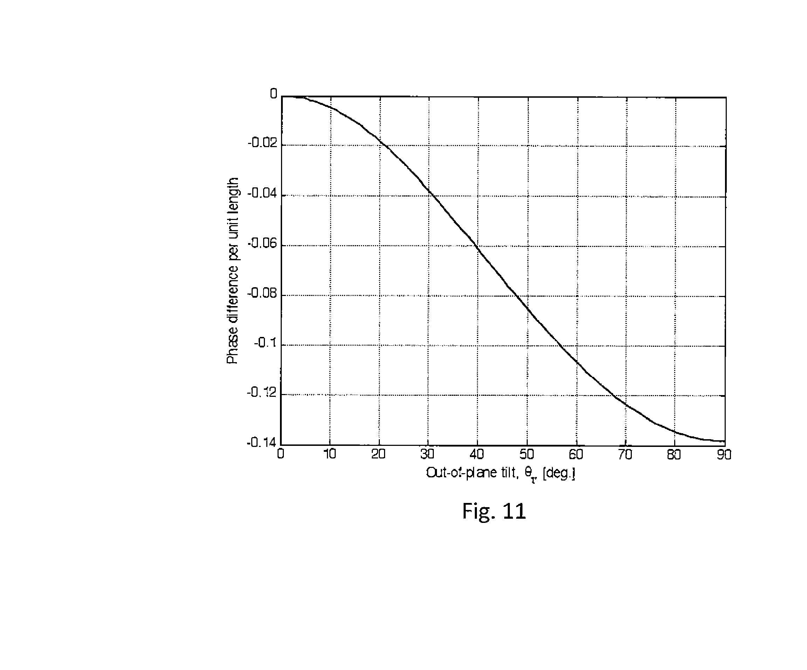

where $n_e(\lambda)$ and $n_o(\lambda)$ are the dispersion of the extraordinary and ordinary indices of the uniaxial material. In terms of advancing phase, relative to an A-plate aligned pixel ($\theta_t=0$), Eq. (1) gives a non-linear increase of phase ramp with increase of out-of plane tilt. The phase difference relative to an A-plate configured pixel (i.e., $n_a(\theta_t; \lambda)-n_e(\lambda)$) is plotted in Fig. 11. From the plot, an encoding pixel, aligned with the LC tilt at ~56.7°, yields a phase difference per unit length of - 0.1. In other words, a 2mm pixel height provides for 200nm phase advance relative to the A-plate pixel. This gives the required $\pi$ phase step at $\lambda=400$nm.

In this manner, the relative phase delay through each microscopic LC domain is made to be dependent on the out-of-plane tilt of the LC molecules. This is pure phase modulation. The constant amplitude term at each XY site can be neglected. The complex amplitude of each phase cell partition, arriving at the detector resolution is given by,

$$A_{ij}(x,y;t) = \exp\left[j\phi_{ij}(x,y;t;\theta_t)\right]. \tag{3}$$

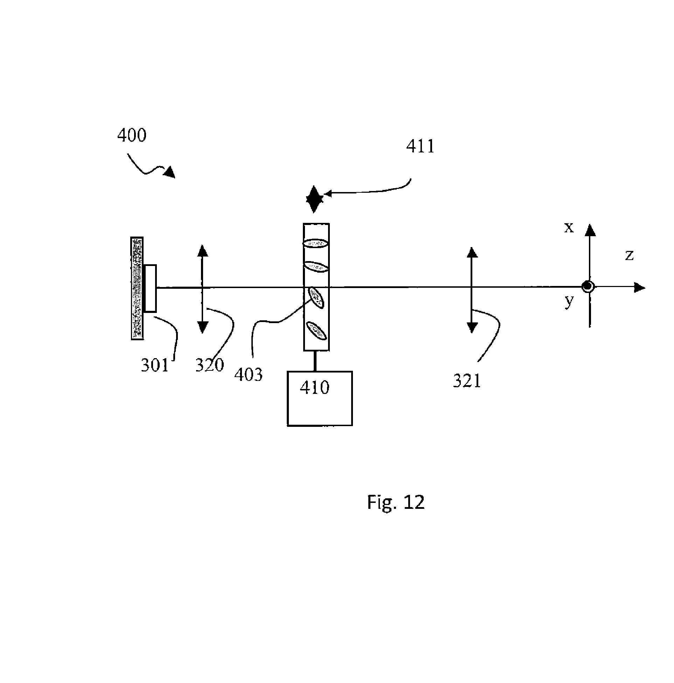

In order for the spatially varying tilt LC layer to function as a random modulation device for reducing speckle, the tilt angle is typically varied in time in order to create an active diffuser. Referring to Fig. 12, a sub-system 400 of a projection system including an actuated active diffuser for applying the random modulation to sub-resolution beams is shown. In particular, the sub-system 400 includes a coherent laser source 301 having a linear output polarization 320. The diffuser 403 includes a LC retarder having randomly tilted micro-domains. For illustrative purposes, the projection of the LC director is shown along the device cross-section at different XY sites. The diffuser 403 is translated in time by an actuator 410 (e.g., electronics/opto-mechanics). Each optical stream propagates as e-wave in this configuration. As such, the output polarization is unchanged, as shown by the linear polarization 321. The diffuser creates temporal modulation differences within each interval of the detector. In this example, the active diffuser is linearly translated along the LC director tilt plane, as shown by the arrow of 411. The laser beam propagates along Z-direction. By randomly presenting varying phase of light beams to each sub-resolution area over one detector integration time, a series of uncorrelated or partially correlated speckle patterns are created at the detector. The averaging over sub-resolution areas and over time enables the intensity non-uniformity to be reduced.

The laser-based illumination sub-system depicted in Fig. 12 can be incorporated into display systems utilizing both an intensity modulation panel (e.g., DLP) and polarization-based modulation panels (e.g., transmissive LCD or reflective LC on silicon). Since the random diffuser can be fabricated such that the tilt angle is spatially varied while the fast axis is constant, the random diffuser advantageously preserves the state of polarization in the illumination, and thus is ideal for polarization-based systems. In the intensity based display system, the polarization output of the laser illumination and active diffuser does not need to be preserved. In each case, the fabricating the despeckle device to have LTD advantageously provides a variation in tilt angle on a scale ideal for reducing the perceived speckle pattern in laser illumination systems. For example, in general the average width of the LTD is typically less than 100 microns, often between 5 and 10 microns. Of course, LTDs having a smaller or larger width are both possible and envisaged.

In yet another embodiment of the instant invention, the spatially varying tilt retarders are used to form polarizing holograms, as for example, disclosed in US Pat. Appl. No. 20090009668. In yet other embodiments, the spatially varying tilt retarders are used in optical trapping, optical tweezer, or optical coherence tomography applications.

Of course, the above embodiments have been provided as examples only. It will be appreciated by those of ordinary skill in the art that various modifications, alternate configurations, and/or equivalents will be employed without departing from the spirit and scope of the invention. In particular, the methods of forming LTD using sufficiently low dosage of LPUV light can be combined with any of the other methods of forming spatially varying tilt layers. In addition, while the LPP/LCP system described above has been shown to provide the LTD (e.g., the plurality of discrete regions), other O-plate LPP/LCP systems are expected to provide similar results with similar LPUV doses. Accordingly, the scope of the invention is therefore intended to be limited solely by the scope of the appended claims.

**Claims**

1. A method of fabricating an optical element including a liquid crystal layer having a spatially-varying tilt angle, the method comprising the steps of:

   a) coating a substrate with a linearly photopolymerizable polymer layer;
   b) irradiating the linearly photopolymerizable polymer layer with linearly polarized ultra-violet light at a oblique angle; and,
   c) coating a layer of liquid crystal material on a surface of the irradiated linearly photopolymerizable polymer layer, wherein the liquid crystal material has a predetermined relationship between its tilt angle and a total dose of the linearly polarized ultra-violet light, and
   wherein the linearly photopolymerizable polymer layer is irradiated with at least one dose of linearly polarized ultra-violet light that is sufficient to induce formation of a plurality of discrete regions within the liquid crystal layer having a larger in-plane birefringence than an adjacent region.

2. A method according to claim 1, wherein the liquid crystal material includes a liquid crystal polymer precursor, and comprising the step of:

   d) irradiating the liquid crystal layer having the plurality of discrete regions with ultra-violet light to form a liquid crystal polymer.

3. A method according to claim 2, wherein step b) comprises:

   irradiating the linearly photopolymerizable polymer layer with the least one dose of linearly polarized ultra-violet light that is sufficient to induce formation of the plurality of discrete regions; and
   irradiating the linearly photopolymerizable polymer layer with a second dose of linearly polarized ultra-violet light through a photomask.

4. A method according to claim 3, wherein the photomask includes at least two discrete regions of different levels of transmission for the linearly polarized ultraviolet light.

5. A method according to claim 3, wherein the photomask is a variable transmission mask having continuously varying transmission for the linearly polarized ultraviolet light.

6. A method according to claim 3, wherein the photomask is a grating photomask.

7. A method according to claim 3, wherein the least one dose and the second dose are provided with linearly polarized light having different azimuthal orientations relative to the substrate.

8. A method according to claim 1, wherein step b) comprises:

   irradiating the linearly photopolymerizable polymer layer with the least one dose of linearly polarized ultra-violet light that is sufficient to induce formation of the plurality of discrete regions; and
   irradiating the linearly photopolymerizable polymer layer with a second dose of linearly polarized ultra-violet light through a photomask.

9. A method according to claim 8, wherein step b) comprises:

moving at least one of the photomask and the substrate while irradiating the linearly photopolymerizable polymer layer with the second dose of linearly polarized ultra-violet.

10. A method according to claim 1, wherein the plurality of discrete regions within the liquid crystal layer and the surrounding region have a same slow axis azimuthal orientation.

11. A method according to any of claims 1 to 10, wherein the substrate includes one of an ultra-violet anti-reflection coating and an ultra-violet absorbing coating disposed on a back surface of the substrate.

12. A method according to any of claims 1 to 10, wherein the at least one dose is less than 40 mJ/cm$^2$.

13. A method according to any of claims 1 to 10, wherein the at least one dose is less than 30 mJ/cm$^2$.

14. A method according to any of claims 1 to 10, wherein the plurality of discrete regions are randomly or pseudo-randomly distributed.

15. A method according to any of claims 1 to 10, wherein the optical element is for reducing speckle in a laser illumination system.

Fig. 1a

Fig. 1b

EP 2 284 581 A1

Fig. 1c

Fig. 1d

10

11

10

11

y

z

x

Fig. 2

Fig. 3

40 mJ/cm2 (unmasked; LPUV azimuth 0° ) / 100 mJ/cm2 (masked; LPUV azimuth 0° )

Fig. 4

EP 2 284 581 A1

40 mJ/cm2 (unmasked; LPUV azimuth 56.7° ) / 100 mJ/cm2 (masked; LPUV azimuth 0° )

Low tilt non-grating region @BS b/w x-pol.

Low tilt non-grating region @DS b/w x-pol.

Low tilt grating region @DS b/w x-pol.

Fig. 5

BS b/w x-polarizers

Retardance

FA

Sawtooth
dose aperture

scanning
exposure

Fig. 6

Fig. 7

Fig. 8

EP 2 284 581 A1

Fig. 9

(a)

(b)

Fig. 10

Fig. 11

Fig. 12

Europäisches
Patentamt
European
Patent Office
Office européen
des brevets

## EUROPEAN SEARCH REPORT

Application Number

EP 10 17 1889

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 012 173 A2 (JDS UNIPHASE CORP [US]) 7 January 2009 (2009-01-07) * paragraph [0071] - paragraph [0074] * * figures 3,4-7,9a,9b * | 1-6,8-15 | INV. G02B5/30 G02B27/48 G03F7/00 G03H1/32 |
| A | US 2005/128380 A1 (ZIEBA JERRY [US] ET AL ZIEBA JERRY [US] ET AL) 16 June 2005 (2005-06-16) * paragraph [0045] - paragraph [0050] * * figures 2-7 * | 1-15 | |
| A | EP 1 286 188 A2 (FUJI PHOTO FILM CO LTD [JP]) 26 February 2003 (2003-02-26) * paragraph [0103] - paragraph [0155] * * figures 1a-1e * | 1-15 | |

TECHNICAL FIELDS
SEARCHED      (IPC)

G02B
G03F
G03H

The present search report has been drawn up for all claims

| Place of search | Date of completion of the search | Examiner |
|---|---|---|
| Munich | 27 September 2010 | von Hentig, Roger |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 10 17 1889

This annex lists the patent family members relating to the patent documents cited in the above-mentioned European search report.
The members are as contained in the European Patent Office EDP file on
The European Patent Office is in no way liable for these particulars which are merely given for the purpose of information.

27-09-2010

| Patent document cited in search report | | Publication date | Patent family member(s) | | Publication date |
|---|---|---|---|---|---|
| EP 2012173 | A2 | 07-01-2009 | CN | 101339335 A | 07-01-2009 |
| | | | JP | 2009015329 A | 22-01-2009 |
| | | | KR | 20090004696 A | 12-01-2009 |
| | | | US | 2009009668 A1 | 08-01-2009 |
| US 2005128380 | A1 | 16-06-2005 | NONE | | |
| EP 1286188 | A2 | 26-02-2003 | JP | 2003066213 A | 05-03-2003 |
| | | | JP | 2003066214 A | 05-03-2003 |
| | | | KR | 20030017381 A | 03-03-2003 |
| | | | TW | 554220 B | 21-09-2003 |
| | | | US | 2003137632 A1 | 24-07-2003 |

For more details about this annex : see Official Journal of the European Patent Office, No. 12/82

## REFERENCES CITED IN THE DESCRIPTION

**Patent documents cited in the description**

- US 61232313 B
- US 20090009668 A, Tan
- US 6323984 B
- US 06747781 B
- US 12424168 B

**Non-patent literature cited in the description**

- **J.W. Goodman et al.** Speckle reduction by a moving diffuser in laser projection displays. Annual Meeting of the Optical Society of America, 2000
- **L. Wang et al.** Speckle reduction in laser projection systems by diffractive optical element. *Appl. Opt.,* 1998, vol. 37, 177-1775